# EUROPEAN PATENT SPECIFICATION

(11) **EP 0 566 360 B1**
(45) Date of publication and mention of the grant of the patent: **05.02.1997**
(21) Application number: 93302850.8
(22) Date of filing: 13.04.1993
(51) Int. Cl.: H05K 3/00, H01L 21/48, C04B 41/83

(54) **Process for the production of substrate for printed wiring**
Verfahren zur Herstellung von Substraten für gedruckte Schaltungen
Procédé de production de substrats pour circuits imprimés

(30) Priority: 13.04.1992 JP 92772/92; 13.11.1992 JP 303796/92
(43) Date of publication of application: 20.10.1993
(73) Proprietor: MITSUBISHI GAS CHEMICAL COMPANY, INC., Chiyoda-ku, Tokyo (JP)
(72) Inventor: Ohya, Kazuyuki, c/o Mitsubishi Gas Chemical Co.Inc, Chiyoda-ku, Tokyo (JP); Sayama, Norio, c/o Mitsubishi Gas Chemical Co. Inc, Chiyoda-ku, Tokyo (JP)
(74) Representative: Cresswell, Thomas Anthony

(56) References cited:
- EP-A- 0 196 865
- PROCEEDINGS OF THE 37TH ELECTRONIC COMPONENTS CONFERENCE, 11-13 May 1987, Boston, Massachusetts ,IEEE pages 392 - 397 , XP12301 IWATA et al.:'New ceramic and plastic composite for face down bonding & large size silicon chip mounting'
- PATENT ABSTRACTS OF JAPAN vol. 013, no. 307 (E-787)13 July 1989;& JP-A-1082689
- PATENT ABSTRACTS OF JAPAN vol. 015, no. 375 (E-1114)20 September 1991;& JP-A-3149891
- PATENT ABSTRACTS OF JAPAN vol. 016, no. 150 (E-1189)14 April 1992;& JP-A-4005882

## Description

The present invention relates to a process for the production of a novel substrate for printed wiring, which has excellent thickness accuracy, a low coefficient of thermal expansion, high heat dissipation properties and high heat resistance, and which is useful for high frequency use and for directly mounting a semiconductor chip.

A printed wiring board for use with high frequency is required to have electric properties such as small thermal dependency and a low dielectric loss tangent. In addition to these requirements, since the wavelength and the thickness of the board are generally in the same range of thickness, the board functions in a way in which parts and chips of a conventional circuit function, and for this reason, the printed wiring board is also required to have high thickness accuracy. Further, a board on which a semiconductor chip is to be directly mounted is required to have a low coefficient of thermal expansion and high heat dissipation properties.

A variety of materials having low dielectric loss tangents and a variety of substrates from ceramics are being developed in order to meet the above requirements, and some of them have been put to practical use.

However, a substrate produced by a conventional lamination method has a thickness accuracy of within ± 5 % at best. Even if the production of the board or the board itself is devised, the ultimate thickness accuracy is within ±2 %.

For producing a substrate from a ceramic, it is essential to produce the substrate by calcining the ceramic at a high temperature. Therefore, when a thin substrate having a thickness of about 1/40" (0.635 mm) is produced, it is difficult to maintain its thickness accuracy precisely, and further, it is very difficult to produce a substrate free of distortion and strain.

Ceramic materials can give a substrate having a low coefficient of thermal expansion and high heat dissipation properties. However, ceramic material is generally poor in machinability. Therefore, studies are being made of a method in which a substrate having through holes is produced by calcining a green sheet having holes in predetermined positions, or of a method in which a printed wiring network is formed on a green sheet from an electrically conductive paste which can be calcined at a high temperature, and the green sheet is calcined. And, the practical use of these methods is under way. However, the defects with these methods are that the production steps are complicated and that printed wiring boards obtained by these methods are expensive.

The development of machinable ceramics has been recently under way, and most of them are inorganic continuous porous materials. Since, however, the continuous porous material easily absorbs a liquid into their pores due to its continuous porous property, it is impossible to form a printed wiring network, for example, by electroless copper plating. Further, non-oxide-based ceramics are generally liable to react with water. In particular, AIN generates ammonia when heated to 80°C or higher in the presence of water, and it is converted into β-alumina or aluminum hydroxide. As a result, when the inorganic continuous porous material imparted with machinability is used as a substrate for printed wiring, it is essentially required to form a printed wiring network in a dry state and form a resist coating in a dry state.

Further, it is conceivable to employ a method in which a block of an inorganic continuous porous material is produced from a ceramic and the block is sliced in a dry method to prepare substrates. However, although being excellent in flexural strength, this inorganic continuous porous material has inferior impact resistance. When it has a decreased thickness, it is easily fractured and difficult to slice. Moreover, it is much more difficult to process such a fragile substrate for forming a printed wiring.

According to JP-3-149891, there is disclosed a board for a circuit made by mixing ceramic powder and glass fibres and moulding into a plate or columnar shape. The material is then impregnated with a resin while being deaerated. The compact may then be cut into plates.

It is an object of the present invention to provide a process for the production of a novel substrate for printed wiring, which has high thickness accuracy and permits the formation of a printed wiring network by most general methods such as wet electroless copper plating without impairing the excellent properties of an inorganic continuous porous material such as a low coefficient of thermal expansion, high heat dissipation properties and high machinability.

According to the present invention, there is provided a process for the production of a substrate for printed wiring, which comprises wrapping a plate-like inorganic continuous porous material (1) having a thickness of 2 to 10cm, (to be abbreviated as "Material (I)" hereinafter) with a cloth or paper (IV), impregnating the wrapped material with a thermosetting resin (II) under reduced pressure, curing the thermosetting resin to form a composite material (III), and slicing the composite material (III) , after removal of the cured resin and the cloth or paper (IV) which cover sides of the composite material at right angles with respect to the slicing direction, into substrates having a predetermined thickness.

In the Material (I) used in the process of the present invention, the porosity is 10 to 40 %, preferably 12 to 30 %, and the average pore diameter is 0.1 to 10 µm, preferably 0.5 to 6 µm. The Material (I) is preferably selected from the group consisting of aluminum nitride-hexagonal boron nitride (AlN-h-BN), alumina-hexagonal boron nitride (Al₂O₃-h-BN), zircon oxide-hexagonal boron nitride (ZrO₂-h-BN), silicon nitride-hexagonal boron nitride (Si₃N₄-h-BN), hexagonal boron nitride (h-BN), β-wollastonite (β-CaSiO₃), and mica.

In the present invention, the cloth or paper (IV) is preferably selected from a glass woven fabric and a glass nonwoven fabric. The Material (I) includes an integrated block obtained by stacking a plurality of blocks of the Materials (I) to form a pile and wrapping the pile with the cloth or paper (IV) and an integrated block obtained by stacking a plurality of blocks of the Materials (I) through one or more sheets of the cloth or paper (IV) to form a pile and wrapping the pile with the cloth or paper (IV).

In the present invention, it is preferred to heat-treat the Material (I) under reduced pressure before the impregnation with the thermosetting resin (II). In this case, the Material (I) may be wrapped or unwrapped with the cloth or paper (IV). This heat treatment under reduced pressure is preferably carried out at a temperature between 70 and 250°C under a pressure of 44Pa (30 mmHg) or less for 0.5 to 72 hours.

The thermosetting resin (II) used in the present invention refers to a thermosetting resin that can be cured by addition polymerization. It is preferred to degas the thermosetting resin (II) by heat treatment under reduced pressure before it is used for the impregnation.

In the present invention, the impregnation with the thermosetting resin (II) is preferably carried out by replenishingly supplying the thermosetting resin (II) from under the Material (I) according to a spontaneous impregnation rate at a temperature at which the thermosetting resin (II) is kept in a liquid state.

The composite material (III) is sliced into substrates after the removal of the cured resin and the cloth or paper (IV) which cover sides at right angles with the slicing direction and which are integrated. The composite material (III) is preferably sliced with a multiwire saw or a multiblade saw with diamond fixed on an edge. It is also preferred to use an inner diameter slicing diamond saw for the slicing.

### Inorganic continuous porous material (I)

The Material (I) used in the present invention is generally produced by incorporating a sintering aid and mixing aids such as an organic solvent and water to an inorganic powder as required to form a homogeneous mixture, shaping the mixture into a desired plate, cube, cylinder or other block under a high pressure or ultrahigh pressure under conditions where the mixing aid, etc., can be properly removed, completely removing the mixing aid, etc., by drying or heating, and sintering the shaped body by calcining it.

The Material (I) used in the present invention preferably has the form of a plate whose surface is rectangular or square, in view of the production of the inorganic continuous porous material (I) which shows little variability in physical properties among lots, maintenance of impregnatability and the use thereof as substrate for printed wiring. The Material (I) has a thickness of 2 to 10 cm, and preferably a length of 5 to 30 cm and a width of 5 to 40 cm.

The above inorganic powder can be selected from those which are usable in an electric field in terms of heat resistance, electric properties, etc. In the present invention, the above inorganic powder is selected from those which have machinability as well as the above properties.

Specifically, the above inorganic powder includes a mixture of an aluminum nitride powder and a hexagonal boron nitride powder (for AlN-h-BN), a mixture of an alumina powder and a hexagonal boron powder (Al₂O₃-h-BN), a mixture of a zircon oxide powder and a hexagonal boron nitride powder (ZrO₂-h-BN), a mixture of a silicon carbide powder and a hexagonal boron nitride powder (SiC-h-BN) and a mixture of a silicon nitride powder and a hexagonal boron nitride powder (Si₃N₄-h-BN). The h-BN content of these mixtures is 10 to 50 % by weight, preferably 10 to 25 % by weight. Further, the inorganic powder includes a hexagonal boron nitride powder (h-BN), β-wollastonite (β-CaSiO₃), cordierite, and mica.

The Material (I) is generally produced by calcining the above inorganic powder in the presence of a sintering aid which is to impart the Material (I) with the desired machinability. When a mixture of an aluminum nitride powder and a hexagonal boron nitride powder is used, h-BN works as a sintering aid and a pore former, while the sintering aid can be selected from oxides of rare earth elements typified by yttria and oxides of alkaline earth elements typified by calcia. When β-CaSiO₃ is used, a sintered body having improved heat resistance can be obtained in the presence of 1 to 18 % by weight of MgO as a sintering aid.

When the Material (I) is formed of any one of the above AlN-h-BN, Al₂O₃-h-BN, ZrO₂-h-BN and Si₃-h-BN, the BN component works as a pore former, and the pore diameter depends upon the particle diameter of the h-BN powder. The smaller the particle diameter of the powder is, the smaller the pore diameter is. Further, the smaller the particle diameter of the powder is, the more improved the mechanical strength and processing accuracy are. The porosity differs depending upon the kind and amount of the used sintering aid. On the other hand, when the same sintering aid is used, the porosity differs depending upon the amount of the used h-BN component. With an increase in the amount of the used h-BN component, the porosity increases, while the mechanical strength, etc., decrease. When any one powder of h-BN, β-wollastonite, and mica is used, the pore size is determined depending upon the particle diameter of the used powder. With a decrease in the particle diameter of the powder, the pore size decreases and the mechanical strength and processing accuracy increase.

The substrate for printed wiring, provided by the present invention, is a product formed by integrating the above Material (I) and the thermosetting resin (II). Therefore, the substrate for printed wiring is greatly improved in mechanical and chemical properties. In view of this point, it cannot be necessarily said that substrate having smaller pore diameters is always excellent.

With an increase in the pore diameter, the impregnation becomes easier. With a decrease in the pore diameter, the uniformity of the Material (1) increases. Further, for producing the Material (I) having less variability among lots from a fine powder of a non-oxide material such as a mixture of AIN and h-BN powders, it is also required to control the material and calcining very precisely. In view of the above points, the inorganic continuous porous material (I) is preferably produced by selecting the particle diameter of the inorganic powder to achieve the following. That is, the average pore diameter is 0.1 to 10 µm, preferably 0.5 to 6 µm, and the porosity is generally 10 to 40 %, preferably 10 to 35 %, more preferably 15 to 25 %.

In the substrate for printed wiring, provided by the process of the present invention, for example, the dielectric loss tangent and thermal conductivity are more important than the density, strength and heat resistance, and preferred is the Material (I) which is produced so as to show less variability among lots concerning the above more important properties.

### Cloth or paper (IV)

The cloth or paper (IV) used in the process of the present invention can be selected from those which can endure the temperatures for impregnation with the thermosetting resin (II) and curing it and which inhibits broadening of crack which has occurred in a cured resin. Specific examples of the cloth or paper (IV) include glass woven fabric, glass unwoven fabric, glass woven fabric treated with Teflon, glass unwoven fabric treated with Teflon, ceramic fiber cloth, and the like. In view of the availability, the price and ease of cutting, preferred are glass woven fabric and glass unwoven fabric.

### Thermosetting resin (II)

The thermosetting resin (II) used in the process of the present invention is preferably selected from thermosetting resins which are cured by addition polymerization without forming any byproducts. Specific examples of the thermosetting resin (II) include a phenolic resin, an epoxy resin, an unsaturated polyester resin, a diallyl phthalate resin, an acrylic resin, a cyanato resin (composed from cyanate esters as an essential component), a maleimide resin, a maleimide-vinyl resin, other thermosetting resins and compositions of at least two of these resins. In view of the use for impregnation, preferred are thermosetting resins which are in a liquid state at room temperature or are melted by heating and which have a low viscosity. Of the above resins, preferred is a cyanato resin which includes, for example, a cyanate ester resin, a cyanate ester-maleimide resin, a cyanate ester-maleimide-epoxy resin and a cyanate acid ester-epoxy resin (DE-1,190,184 and U.S. Patent 4,116,946).

An aid for improving the thermosetting resin (II) in the affinity to the Material (I) may be incorporated into the thermosetting resin (II). The above aid includes a silane coupling agent and other coupling agent. The aid is selected by taking into account the inorganic continuous porous material (I) and the thermosetting resin (II) to be used. It is much more preferred to select the thermosetting resin (II) having high affinity to the inorganic continuous porous material (I).

Further, the thermosetting resin (II) may contain a curing catalyst for promoting the curing reaction and a flame retardant for maintaining flame retardancy when the Material (I) has a high porosity.

### Preparation of composite material (III)

### Preliminary treatment of Material (I)

The composite material (III) is formed by wrapping the above Material (I) with one piece, or a plurality of pieces, of the cloth or paper (IV), impregnating the wrapped material with the thermosetting resin (II) and curing the thermosetting resin (II), or by stacking a plurality of the Materials (I) optionally through one sheet or a plurality of sheets of the cloth or paper (IV) to form a pile, wrapping the pile with the cloth or paper (IV), impregnating the wrapped pile with the thermosetting resin (II) and curing the thermosetting resin (II).

The thickness of the above pile as an integrated block is generally 8 cm or more, preferably 15 to 80 cm, particularly preferably 15 to 40 cm in view of easiness in slicing, while this thickness can be properly set depending upon a slicing apparatus such as a diamond saw, multiwire saw, multiblade saw, etc.

The Material (I) is wrapped with the cloth or paper (IV) and impregnated with the thermosetting resin (II).

The reasons for the above wrapping are as follows. First, since the Material (I) and the thermosetting resin (II) attached to the Material (I) greatly differ from each other in curing shrinkage factor and thermal expansion coefficient, the thermosetting resin (II) attached to the surface of the Material (I) undergoes cracking due to its curing. The above wrapping prevents this crack from reaching the interior of the Material (I). Secondly, when the block of the Material (I) having a large size or the pile of a plurality of the Materials (I) is impregnated, the Material(s) (I) is easily dried by heating under reduced pressure due to the presence of the cloth or paper (IV) between the Materials (I). Further, a vary small amount of air, water adsorbed on the material surface and other volatiles can be easily removed from the Material (I) during the impregnation.

The Material (I) is preferably stored in a closed system after being produced. When the Material (I) absorbs water in air, the affinity and adhesion of the Material (I) to the thermosetting resin (II) may be impaired, and the Material (I) may have a portion which cannot be impregnated due to absorbed water.

It is therefore preferred to fully dry the Material (I) before the impregnation. For this purpose, the inorganic continuous porous material (I) is dried at a temperature between 70 and 250°C under a pressure of 4kPa (30 mmHg) or less for 0.5 to 72 hours. Specifically, the Material (I) may be heated stepwise under reduced pressure within the above ranges depending upon the Material (I).

When the Material (I) has absorbed a liquid such as water, it is very difficult to dry it under general conditions. In particular, some of the non-oxide materials undergo a run away reaction at a high temperature required for drying it for a short period of time. It is necessary to take care when such materials are handled. For example, when heated to 80°C or higher in the presence of water, AIN generates ammonia and is converted to β-alumina or aluminum hydroxide.

### Impregnation

The impregnation is carried out by a spontaneous impregnation method in which the above Material (I) and the thermosetting resin (II) whose amount has been measured beforehand are placed in a container or mold which permits decreasing of the pressure and heating as required, preferably decreasing the pressure in the system and heating the thermosetting resin (II) to melt it for the impregnation, or by a method in which the Material (I) is placed in a container or mold which permits decreasing of the pressure and heating, the Material (I) is dehydrated/dried under heat by decreasing the pressure in the system as required, and gradually supplying the thermosetting resin (II), which has been melted and degassed under reduced pressure, preferably from under Material (I) at a rate meeting the impregnation rate.

The gap between the Material (I) and the above container or mold is preferably nearly constant, for example, about 0.5 to 3 mm. When the thickness of the thermosetting resin adhering to the surface of the Material (I) differs from place to place, a bending stress acts on the Material (I). This bending stress can be decreased when the above gap is nearly constant as above.

It is preferred to use a disposable inner container specialized for the impregnation in the above container or mold. The disposable inner container specialized for the impregnation has mold releasability and heat resistance, or it can be cut apart and formed, for example, of aluminum or a resin having a heat resistance against a temperature of 200°C or higher.

The pressure for the impregnation can be set from reduced pressure to high pressure including ultrahigh pressure depending upon the performances of the container or mold and the inner container.

When the Material (I) and the thermosetting resin (II) have high affinity to each other, the preliminary degassing treatment is not necessary. In this case, the Material (I) may be impregnated with the thermosetting resin (II) while degassing the thermosetting resin (II) at atmospheric pressure, and this impregnation is carried out one-directionally or consecutively from one surface to another, whereby the Material (I) is uniformly impregnated with the thermosetting resin (II). However, when the Material is nonuniform, or depending upon controlling the impregnation method, the impregnation is sometimes nonuniform or the Material (I) sometimes has an insufficiently impregnated portion inside. For carrying out the uniform impregnation on the entirety of the Material (I), the pressure for the impregnation is a reduced pressure of 6.7 kPa (50 mmHg) or less, preferably 1.3 kPa (10 mmHg) or less, particularly preferably 0.13 kPa (1 mmHg) or less.

Although differing depending upon the pore diameter of the Material (I), the viscosity of the molten thermosetting resin (II) and some others, the time required for the impregnation is generally 10 minutes to 4 hours.

### Curing

The composite material (III) is obtained by curing the above Material (I). The curing conditions are properly determined depending upon the kind of the thermosetting resin (II), and the like. The curing is preferably carried out so that the impregnated Material (I) is completely cured by preliminarily curing the impregnated Material (I) by heating it in the container or mold, or in the container specialized for the impregnation, further curing it, taking it out of the container, etc., curing it, and then further carrying out post-curing.

### Slicing of the cured composite material (III)

The above composite material (III) is sliced to obtain the substrate for printed wiring, provided by the present invention.

The composite material (III) can be sliced by a method using a slicing apparatus such as an outer diameter slicing diamond saw, an inner diameter slicing diamond saw a multiwire saw or a multiblade saw. According to the process of the present invention, there can be obtained substrates having a thickness of 0.2 mm or more, typically 0.4 to 1.6 mm, and having high thickness accuracy. Further, a thin substrate having a thickness of about 0.1 mm can be produced by carrying out a polishing process, etc. When a multiwire saw or a multiblade saw is used for multi-slicing, it is generally preferred to slice a combination of the composite material into a combination of substrates having a small thickness and substrates having a large thickness at the same time rather than slicing many composite materials having small thicknesses at the same time, although the degree of multi-slicing depends on a slicing apparatus. For slicing the material formed of aluminum nitride, no slicing method has been possible but a dry method in view of safety. However, the present invention permits a wet slicing method, particularly a slicing method using a coolant or an aqueous solution containing an abrasive material.

For slicing, the resin portion integrated with the cloth or paper (IV) wrapping the sides of the Material (I) in the stacking direction is cut off, and the composite material (III) is set in a slicing machine so that the cured resin is not in contact with the saw.

### Substrate formed of composite material (III) for printed wiring

The substrate obtained according to the process of the present invention has very high thickness accuracy, and this substrate can be obtained as one having a very small thickness. Therefore, a substrate which has a high dielectric constant but has a low dielectric loss tangent can be suitably used as a substrate having higher performance for the use with high frequency.

The thermal expansion coefficient of the substrate is greater than that of the Material (I). However, there can be easily obtained a substrate having a thermal expansion coefficient of 10 x 10⁻⁶K⁻¹ or less by selecting an apparent porosity.

The thermal conductivity of the substrate is equivalent to, or higher than, that of the Material (I).

The composite material (III) formed in the present invention is a novel composite material in which the cured resin having a three-dimensional network structure is integrated with the Material (I) having a three-dimensional network structure. Therefore, the composite material (III) has about the same hardness as that of the Material (I) and greatly improved flexibility (impact strength). Therefore, the substrate of the present invention has drilling processability equivalent to, or higher than, that of a general glass epoxy laminate. Further, when the substrate is obtained from the inorganic continuous porous material (I) whose porosity is as large as about 30 %, the substrate easily permits the punching process.

The cured thermosetting resin is integrated with the Material. As a result, the substrate is greatly improved in chemical properties. For example, when the Material (I) having poor water resistance or poor acid resistance such as β-wollastonite is used for producing the substrate of the present invention, the substrate is greatly improved in water resistance or acid resistance due to the thermosetting resin (II) used for the impregnation and cured. When the substrate for printed wiring is produced from the Material (I) of AlN-h-BN, etc., the substrate is structured so that AlN-h-BN having inferior water resistance is surrounded by the three-dimensional network of the resin used for the impregnation. Therefore, the substrate is greatly improved in water resistance and chemical resistance, and it can be sliced by using water as a medium and permits wet electroless plating. When the substrate for printed wiring is produced from the Material (I) of Al₂O₃-h-BN or ZrO₂-h-BN, generally, Al₂O₃ and ZrO₂ as a main component are too stable to carry out etching. In the present invention, however, the substrate permits etching due to the presence of a portion impregnated with the thermosetting resin (II).

Therefore, either the resin side or the inorganic material side, or both are etched with an acidic, alkaline or oxidizing etching solution having room temperature or an elevated temperature as required, and the substrate is surface-treated with a coupling agent, etc., whereby a strongly adhering metal film can be easily formed on the surface or through holes of the substrate by a conventional electroless plating method.

### Production of printed wiring board

Printed wiring can be generally produced on the above substrate for printed wiring by a method in which through holes are made in the substrate as required, then the substrate is plated with a metal and the intended printed wiring network is formed, or by a method in which the substrate is plated with a metal, through holes are made in the substate as required, the through holes are plated and the intended printed wiring network is formed. In particular, the former method works the physical properties of the substrate for printed wiring, provided by the present invention, and permits the formation of a very fine printed wiring network since the through holes and the substrate surface can be plated with copper in the same copper plating thickness and processed for forming the printed wiring.

When the above metal plating is carried out, the substrate is surface-treated, and then plated by a known wet electroless plating method, a sputtering method, other dry method, or copper plating method using copper formate. This surface treatment is carried out by a washing method for cleaning, a method of treatment with a silane coupling agent, particularly an aminosilane coupling agent, a method of etching part of the inorganic material with an acid aqueous solution of phosphoric acid, sulfuric acid or chromic acid, a method of further treating the so-treated substrate with a coupling agent, a method of etching part of the resin with an alkaline aqueous solution of sodium hydroxide or other or a method of treating the so-treated substrate with a coupling agent.

### Examples

The present invention will be explained further in detail hereinafter by reference to Examples. Examples 9 and 10 are presented as examples of use of the products produced by the process of the invention.

### Example 1

A thermosetting resin composition (to be referred to as "resin II-1" hereinafter) was prepared from 87 % by weight of a cyanate ester-maleimide resin (BT-2100, supplied by Mitsubishi Gas Chemical Co., Inc., 2,2-bis(4-cyanotophenyl)propane/bis(4-maleimidophenyl)methane = 9/1), 10 % by weight of a bisphenol A type epoxy resin ("Epikote" 152, supplied by Yuka-Shell Epoxy K.K., epoxy equivalent 172 - 179) and 3 % by weight of γ-glycidoxypropyltrimethoxysilane by mixing these components.

A block of β-wollastonite ("MACHINAX" supplied by INAX Corp., bulk density 2.1, apparent porosity 21 %, average pore radius 3.4 µm) having a size of 15.4 cm x 15.4 cm x 4 cm was wrapped with two layers of glass cloth, and the glass cloth was fixed with a copper wire. The wrapped block was placed in a container, and the pressure in the container was reduced to 0.67 kPa (5 mmHg) Then, the temperature in the container was increased to 110°C, and this temperature was maintained for 1 hour to dry the block under vacuum.

While the above vacuum degree was maintained, the above-prepared resin II-1 was melted at 110°C and injected into the container, and the β-wollastonite was allowed to stand in the container for 1 hour to impregnate it with the resin.

Then, the above resin was cured at 150°C for 1 hour and at 180°C for 2 hours, and further post-cured at 200°C for 3 hours to give a composite material.

The above composite material was sliced with a diamond saw (diamond tool #200, supplied by Nippon Diamond Corp.) to obtain substrates having a size of 15 cm x 15 cm x 0.4 mm and substrates having a size of 15 cm x 15 cm x 1.6 mm.

Further, a substrate having a thickness of 0.2 mm was taken from the above composite material, and polished to give an excellent substrate having a thickness of 0.1 mm.

The substrates having a thickness of 1.6 mm were measured for physical properties. Table 1 shows the results.

### Example 2

Example 1 was repeated except that the β-wollastonite was replaced with β-wollastonite having a bulk density of 1.9, a porosity of 36 % and an average pore radius of 1.8 µm.

The substrates having a thickness of 1.6 mm were measured for physical properties. Table 1 shows the results.

### Referential Examples 1 and 2

The same porous materials as those used in Examples 1 and 2 were measured for physical properties. Table 1 shows the results.

### Example 3

Five blocks of β-wollastonite ("MACHINAX" supplied by INAX Corp., bulk density 2.1, apparent porosity 21 %, average pore radius 3.4 µm) having a size of 15.4 cm x 15.4 cm x 4 cm were stacked one on another through two layers of glass cloth. The resultant pile was wrapped with two layers of the same glass cloth, and the glass cloth was fixed with a copper wire. The wrapped pile was placed in a container with the stacked surfaces being perpendicular, and the pressure in the container was reduced to 0.67 kPa (5 mmHg) Then, the temperature in the container was increased to 110°C, and this temperature was maintained for 1 hour to dry the pile under vacuum.

While the above vacuum degree was maintained, the resin II-1 was melted at 110°C and gradually injected into the container from under the container, and the pile of the β-wollastonite was allowed to stand in the container for 1 hour to impregnate it with the resin.

Then, the above resin was cured at 150°C for 1 hour and at 180°C for 2 hours, and further post-cured at 200°C for 3 hours to give a composite material.

The above composite material was sliced with a multiblade saw (blade thickness 0.25 mm, length 500 mm, using a #600 SiC abrasive spindle oil solution) so that substrates having a size of 15 cm x 15 cm x 0.635 mm and substrates having a size of 15 cm x 15 cm x 1.6 mm were obtained in an equal number.

The substrates having a thickness of 1.6 mm were measured for physical properties. Table 1 shows the results.

**Table 1**

| | REx. 1 | Ex. 1 | REx. 2 | Ex. 1 |
|---|---|---|---|---|
| Bulk density ∗1 g/cm³ | 2.1 | 2.51 | 1.9 | 2.32 |
| Water absorption ∗2 % | porous∗8 | 0.2 | porous∗8 | 0.2 |
| Flexural strength MPa | 75 | 110 | 58 | 140 |
| Dielectric constant ∗3 | 4.8 | 4.0 | 5.8 | 5.4 |
| Dielectric loss tangent ∗4 | 0.011 | 0.006 | 0.007 | 0.0038 |
| Coefficient of thermal expansion ∗5 10⁻⁶K⁻¹ | 7.0 | 8.0 | 7.0 | 10.0 |
| Thermal conductivity ∗6 W(mK)⁻¹ | 1.6 | 3.1 | 1.2 | 1.9 |
| Chemical Resistance ∗7 | | | | |
| 10 % HCl | 38 | 1.1 | collapsed∗8 | 0.8 |
| 10 % NaOH | 0.3 | +0.5 | 0.4 | +1.1 |
| Notes: REx. Referential Example, Ex. = Example | | | | |

| | | | | |
|---|---|---|---|---|
| ∗1: JIS-C-2141, unit g/cm³ | | | | |
| ∗2: JIS-R-1601, unit % | | | | |
| ∗3,∗4: JIS-C-2141, measured at 1 MHz | | | | |
| ∗5: Measurement range, room temperature - -> 300°C, unit x10⁻⁶K⁻¹ | | | | |
| ∗6: Measured by a laser flash method, unit W(mK)⁻¹ | | | | |
| ∗7: Sample 50 mm x 50 mm x 1.6 mm immersed at 23°C, 24 hours, and measured elution amount, unit mg/cm². "+" shows an increase. | | | | |
| ∗8: "porous" and "collapsed" mean "unmeasurable". | | | | |

### Example 4

A thermosetting resin composition (to be referred to as "resin II-2" hereinafter) was prepared from 95 % by weight of a cyanate ester-maleimide resin (BT-2100, supplied by Mitsubishi Gas Chemical Co., Inc., 2,2-bis(4-cyanotophenyl)propane/bis(4-maleimidophenyl)methane = 9/1) and 5 % by weight of a bisphenol A type epoxy resin ("Epikote®" 152, supplied by Yuka-Shell Epoxy K.K., epoxy equivalent 172 - 179) by mixing these components.

Then, the procedures of Example 1 were repeated except that the resin II-I was replaced with the resin II-2 and that the β-wollastonite was replaced with AlN-h-BN having a size of 6 x 6 x 2.5 cm and having an h-BN content of 12.5 %, a bulk density of 2.45, a porosity of 20.6 % and an average radius of 0.66 µm. The above aluminum nitride-hexagonal boron nitride had been preliminarily dried at 70°C for 72 hours.

Substrates having a thickness of 1.6 mm were measured for physical properties. Table 2 shows the results. Specifically, the substrates were measured for dielectric constants and dielectric loss tangents when they were in a dry state, after they were allowed to stand at a relative humidity of 55 % for 24 hours and after they were immersed in water for 48 hours. Further, the substrates which had been allowed to stand at a relative humidity of 55 % for 24 hours were examined for temperature dependency of their dielectric constants and dielectric loss tangents by measuring them at temperatures shown in Table 2. The substrates were also examined for temperature dependence of their thermal conductivity by measuring them at temperatures shown in Table 2.

### Referential Example 3

The same aluminum nitride-hexagonal boron nitride composite material was also measured for physical properties. Table 2 shows the results.

Table 2 clearly shows that the substrate for printed wiring, provided by the process of the present invention, is greatly improved in strength and permits the immersion in water and the measurement of chemical resistance. Further, the decrease in the physical property values of the substrate obtained by the process of the present invention after the immersion in water and the test on chemical resistance is very small. Moreover, it can be understood that the substrate of the present invention shows thermal conductivity and a coefficient of thermal expansion which are in no way inferior to the properties of the aluminum nitride-hexagonal boron nitride.

**Table 2**

| | REx. 2 | Ex. 4 |
|---|---|---|
| Bulk density ∗1 g/cm³ | 2.45 | 2.73 |
| Water absorption ∗2 % | porous∗8 | 0.1 |
| Flexural strength MPa | 110 | 170 |
| Dielectric constant ∗3 | | |
| In a dry state | 6.8 | 6.3 |
| After 24 hours at 55%RH | - | 6.45 |
| 50°C | - | 6.55 |
| 100°C | - | 6.57 |
| 150°C | - | 6.58 |
| 200°C | - | 6.61 |
| After immersion for 46 hours | porous | 6.5 |
| Dielectric loss tangent ∗4 | | |
| In a dry state | 0.0015 | 0.0020 |
| After 24 hours at 55%RH | - | 0.0025 |
| 50°C | - | 0.0024 |
| 100°C | - | 0.0021 |
| 150°C | - | 0.0022 |
| 200°C | - | 0.0020 |
| After immersion for 48 hurs | porous | 0.0071 |
| Coefficient of thermal expansion ∗5 10⁻⁶K⁻¹ | 4.9 | 5.1 |
| Thermal conductivity ∗6W(mK)⁻¹ | | |
| 20°C | 70 | 71 |
| 105°C | 66 | 67 |
| 190°C | 60 | 60 |
| 295°C | 52 | 52 |
| Chemical resistance ∗7 mg/cm² | | |
| 10 % HCl | - | +0.3 (0.15) |
| 10 % NaOH | - | +0.5 (0.25) |

| | | |
|---|---|---|
| Notes: REx. = Referential Example, Ex. = Example ∗1: JIS-C-2141, unit g/cm³ | | |
| ∗2: JIS-R-1601, unit % | | |
| ∗3,∗4: JIS-C-2141, measured at 1 MHz | | |
| ∗5: Measurement range, room temperature - -> 300°C, unit x10⁻⁶K⁻¹ | | |
| ∗6: Measured by a laser flash method, unit W(mK)⁻¹ | | |
| ∗7: Sample 50 mm x 50 mm x 1.6 mm immersed at 23°C 24 hours, and measured elution amount, unit mg/cm². "+" shows an increase. | | |
| ∗8: "porous" and "collapsed" mean "unmeasurable". ∗9: Not measured. | | |

### Examples 5 - 7

Example 4 was repeated except that the AlN-h-BN was replaced with AlN-h-BN having h-BN content of 12.5 %, a bulk density of 2.46, a porosity of 21.4 % and an average pore radius of 1.1 µm (Example 5), AlN-h-BN having h-BN content of 15 %, a bulk density of 2.35, a porosity of 25.4 % and an average pore radius of 0.78 µm (Example 6), and AlN-h-BN having h-BN content of 20 %, a bulk density of 2.05, a porosity of 32.3 % and an average pore radius of 1.2 µm (Example 7).

The substrates having a thickness of 1.6 mm were measured for thermal conductivity to show 66 W(mK)⁻¹ in Example 5, 59 W(mK)⁻¹ in Example 6 and 29 W(mK)⁻¹ in Example 7. In the substrate having a thickness of 0.635, obtained in Example 7, through-holes could be easily made by punching.

### Example 8

Four pieces of Al-h-BN having h-BN content of 12.5 %, a bulk density of 2.46, a porosity of 21.4 % and an average pore radius of 1.1 µm were stacked one on another through two layers of a glass cloth, and the resultant pile was wrapped with the same glass cloth as above. The cloth was fixed with a copper wire. The pile was dried at 70°C for 72 hours. Then, the pile was treated in the same manner as in Example 4 to give a composite material.

The above composite material sliced with a multiblade saw (blade thickness 0.25 mm, length 500 mm, using a #600 SiC abrasive spindle oil solution) so that substrates having a size of 15 cm x 15 cm x 0.635 mm and substrates having a size of 15 cm x 15 cm x 1.6 mm were obtained in an equal number.

The substrates having a thickness of 1.6 mm were measured for physical properties to show the same results as those obtained in Example 4.

### Example 9

Many through holes having a diameter of 0.4 mm were drilled in predetermined positions on the substrate having a thickness of 0.635 mm, obtained in Example 3. The substrate was immersed in an aqueous solution containing 5 % of a phosphoric acid for 2 minutes to carry out the etching treatment of the substrate, and washed with water. Then, the substrate was immersed in an aqueous solution containing 1 % of N-(β-(aminoethyl)-γ-aminopropyltrimethoxysilane for 3 minutes, and then dried at 110°C for 5 minutes. The substrate was plated with copper by electroless plating and further by electrolytic plating to form a copper film having a thickness of 15 µm. The resultant copper-clad substrate was measured for a copper foil peel strength, and the surfaces (degree of unevenness) of walls of the sectioned through holes were observed. Table 3 shows the results.

### Example 10

Example 9 was repeated except that the substrate was replaced with the substrate having a thickness of 0.635 mm obtained in Example 8 and that the etching treatment was omitted. Table 3 shows the results.

**Table 3**

| | Unit | Example 9 | Example 10 |
|---|---|---|---|
| Inorganic porous material | | β-wollastonite | AlN-h-BN |
| Copper foil kg/cm peel strength | kg/cm | 1.5 | 1.6 |
| Degree of unevenness of (µm) hole wall (maximum) | (µm) | 0.4 | 0.3 |

As explained above, the substrate for printed wiring, obtained according the process of the present invention, has remarkably high thickness accuracy since it is produced by cutting the composite material, and further it can be also produced as one having a thickness of 2 mm. Further, the substrate has a low coefficient of thermal expansion and high heat dissipation properties and has higher heat resistance than a cured product of the resin used for the impregnation. The substrate is therefore a novel substrate which retains excellent properties of ceramics and is imparted with the processability of plastics. The substrate is useful as a substrate for an antenna for high frequency, a part module for high frequency and others and as a substrate for directly mounting semiconductor chips.

## Claims

1. A process for the production of a substrate for printed wiring, which comprises wrapping a plate-like inorganic continuous porous material having a thickness of 2 to 10 cm, with a cloth or paper, impregnating the wrapped inorganic continuous porous material with a thermosetting resin under reduced pressure, curing the thermosetting resin to form a composite material, and slicing the composite material after the removal of the cured resin and the cloth or paper which cover the sides of the composite material at right angles with respect to the slicing direction, into substrates having a predetermined thickness.

2. A process according to claim 1, wherein the inorganic continuous porous material has a porosity of 10 to 40% and an average pore diameter of 0.1 to 10 µm.

3. A process according to claim 2, wherein the inorganic continuous porous material has a porosity of 12 to 30% and an average pore diameter of 0.5 to 6 µm.

4. A process according to any one of the preceding claims wherein the inorganic continuous porous material is formed of aluminum nitride-hexagonal boron nitride , alumina-hexagonal boron, zircon oxide-hexagonal boron nitride, silicon nitride-hexagonal boron nitride, hexagonal lattice boron nitride, β-wollastonite or mica.

5. A process according to any one of the preceding claims, wherein the cloth or paper is a glass woven fabric or a glass unwoven fabric.

6. A process according to any one of the preceding claims, wherein the wrapped inorganic continuous porous material is an integrated block prepared by stacking a plurality of inorganic continuous porous materials to form a pile and wrapping the pile with the cloth or paper.

7. A process according to claim 6, wherein the integrated block is prepared by stacking a plurality of inorganic continuous porous materials one on another through one or more layers of the same cloth or paper as the cloth or paper to form a pile and wrapping the pile with the cloth or paper.

8. A process according to any one of the preceding claims, wherein the inorganic continuous porous material is preliminarily heat-treated under reduced pressure before it is impregnated with the thermosetting resin.

9. A process according to claim 8, wherein the preliminary heat-treatment is carried out at 70-250°C under 4 kPa (30 mmHg) or less for 0.5 to 72 hours.

10. A process according to any one of the preceding claims, wherein the thermosetting resin is a resin which is cured by addition polymerization.

11. A process according to any one of the preceding claims, wherein the thermosetting resin is degassed by heat-treating it under reduced pressure before the wrapped inorganic continuous porous material is impregnated therewith.

12. A process according to any one of the preceding claims, wherein the wrapped inorganic continuous porous material is impregnated with the thermosetting resin by replenishingly supplying the thermosetting resin from under the inorganic continuous porous material at a spontaneous impregnation rate at a temperature at which the thermosetting resin is maintained in a liquid state.

13. A process according to any one of the preceding claims, wherein the composite material is sliced with a multiwire saw or a multiblade saw.

14. A process according to claim 13, wherein the multiwire saw or multiblade saw is a saw with diamond on an edge.

15. A process according to any one of the preceding claims, wherein the cured composite material is sliced with an inner diameter slicing diamond saw.

## Patentansprüche

1. Verfahren zur Herstellung eines Substrats für eine gedruckte Schaltung, umfassend das Umhüllen eines plattenförmigen anorganischen kontinuierlichen porösen Materials mit einer Dicke von 2 bis 10 cm mit einem Tuch oder Papier, Imprägnieren des umhüllten anorganischen kontinuierlichen porösen Materials mit einem heiß-härtenden Harz unter vermindertem Druck, Härten des heiß-härtenden Harzes zur Bildung eines Verbundmaterials und Schneiden des Verbundmaterials nach Entfernung des gehärteten Harzes und des Tuchs oder Papiers, die die Seiten des Verbundmaterials bedecken, im rechten Winkel, bezogen auf die Schneiderichtung, in Substrate mit einer vorbestimmten Dicke.

2. Verfahren nach Anspruch 1, wobei das anorganische kontinuierliche poröse Material eine Porosität von 10 bis 40 % und einen mittleren Porendurchmesser von 0,1 bis 10 µm besitzt.

3. Verfahren nach Anspruch 2, wobei das anorganische kontinuierliche poröse Material eine Porosität von 12 bis 30 % und einen mittleren Durchmesser von 0,5 bis 6 µm besitzt.

4. Verfahren nach einem der vorangehenden Ansprüche, wobei das anorganische kontinuierliche poröse Material gebildet worden ist aus Aluminiumnitrit/hexagonalem Bornitrid, Tonerde/hexagonalem Bor, Zirkonoxid/hexagonalem Bornitrid, Siliciumnitrid/hexagonalem Bornitrid, Bornitrid mit hexagonalem Gitter, β-Wollastonit oder Glimmer.

5. Verfahren nach einem der vorangehenden Ansprüche, wobei das Tuch oder Papier ein Glasgewebe oder Glasvliesstoff ist.

6. Verfahren nach einem der vorangehenden Ansprüche, wobei das umhüllte anorganische kontinuierliche poröse Material ein integrierter Block ist, der hergestellt worden ist durch Aufeinanderstapeln einer Mehrzahl von anorganischen kontinuierlichen porösen Materialien zur Bildung eines Stapels und Umhüllen des Stapels mit dem Tuch oder Papier.

7. Verfahren nach Anspruch 6, wobei der integrierte Block hergestellt worden ist durch Aufeinanderstapeln einer Mehrzahl von anorganischen kontinuierlichen porösen Materialien über eine oder mehrere Schichten des gleichen Tuchs oder Papiers, wie das Tuch oder Papier zur Bildung eines Stapels und Umhüllen des Stapels mit dem Tuch oder Papier.

8. Verfahren nach einem der vorangehenden Ansprüche, wobei das anorganische kontinuierliche poröse Material vorher unter vermindertem Druck erhitzt wird, bevor es mit dem heiß-härtenden Harz imprägniert wird.

9. Verfahren nach Anspruch 8, wobei die vorherige Wärmebehandlung bei 70 bis 250°C unter 4 kPa (30 mmHg) oder weniger während 0,5 bis 72 Stunden durchgeführt wird.

10. Verfahren nach einem der vorangehenden Ansprüche, wobei das heiß-härtende Harz ein Harz ist, das durch Additionspolymerisation gehärtet wird.

11. Verfahren nach einem der vorangehenden Ansprüche, wobei das heiß-härtende Harz durch Wärmebehandlung unter vermindertem Druck entgast wird, bevor das umhüllte anorganische kontinuierliche poröse Material damit imprägniert wird.

12. Verfahren nach einem der vorangehenden Ansprüche, wobei das umhüllte anorganische kontinuierliche poröse Material mit dem heiß-härtenden Harz imprägniert wird durch Einfüllen des heiß-härtenden Harzes von unter dem anorganischen kontinuierlichen porösen Material mit einer kontinuierlichen Imprägniergeschwindikgeit bei einer Temperatur, bei der das heiß-härtende Harz in flüssiger Form gehalten wird.

13. Verfahren nach einem der vorangehenden Ansprüche, wobei das Verbundmaterial mit einer Mehrdrahtsäge oder einer Mehrblattsäge in Scheiben geschnitten wird.

14. Verfahren nach Anspruch 13, wobei die Mehrdrahtsäge oder Mehrblattsäge eine Säge mit Diamanten an der Kante ist.

15. Verfahren nach einem der vorangehenden Ansprüche, wobei das gehärtete Verbundmaterial mit einer Innendurchmesser-Diamantscheibensäge in Scheiben geschnitten wird.

## Revendications

1. Procédé de fabrication d'un substrat pour circuits imprimés consistant à emballer un matériau minéral poreux à cellules ouvertes en forme de plaque d'une épaisseur de 2 à 10 cm, avec un tissu ou papier, à imprégner sous pression réduite le matériau minéral poreux à cellules ouvertes avec une résine thermodurcissable, à durcir la résine thermodurcissable pour former un matériau composite et à trancher le matériau composite, après avoir éliminée la résine durcie et le tissu ou papier couvrant les faces du matériau composite formant un angle droit par rapport à la direction de tranchage, ce qui donne des substrats d'une épaisseur prédéterminée.

2. Procédé conforme à la revendication 1 dans lequel le matériau minéral poreux à cellules ouvertes a une porosité de 10 à 40 % et un diamètre moyen des pores compris entre 0,1 et 10 µm.

3. Procédé conforme à la revendication 2 dans lequel le matériau minéral poreux à cellules ouvertes a une porosité comprise entre 12 et 30 % et un diamètre moyen des pores compris entre 0,5 et 6 µm.

4. Procédé conforme à l'une quelconque des revendications précédentes dans lequel le matériau minéral poreux à cellules ouvertes est composé de nitrure d'aluminium-nitrure de bore hexagonal, d'oxyde d'aluminium-nitrure de bore hexagonal, d'oxyde de zirconium-nitrure de bore hexagonal, de nitrure de silicium-nitrure de bore hexagonal, de nitrure de bore à réseau hexagonal, de β-wollastonite ou de mica.

5. Procédé conforme à l'une quelconque des revendications précédentes dans lequel le tissu ou papier est un produit textile en fibres de verre tissé ou non tissé.

6. Procédé conforme à l'une quelconque des revendications précédentes, dans lequel le matériau minéral poreux à cellules ouvertes est un bloc en une seule pièce, préparé par empilement de plusieurs matériaux minéraux à cellules ouvertes pour former une pile et emballage de la pile avec le tissu ou papier.

7. Procédé conforme à la revendication 6 dans lequel on prépare le bloc en une seule pièce par empilement de plusieurs matériaux minéraux poreux à cellules ouvertes les unes sur les autres, en utilisant une ou plusieurs couches du même tissu ou papier que celui servant à l'emballage, afin de former une pile, et par emballage de la pile avec le tissu ou papier.

8. Procédé conforme à l'une quelconque des revendications précédentes dans lequel le matériau minéral poreux à cellules ouvertes est préalablement traité par la chaleur sous pression réduite avant d'être imprégné par la résine thermodurcissable.

9. Procédé conforme à la revendication 8, dans lequel le traitement thermique préliminaire est réalisé à une température comprise entre 70 et 250 °C à une pression de 4 kPa (30 mm de Hg) ou moins pendant 0,5 à 72 heures.

10. Procédé conforme à l'une quelconque des revendications précédentes dans lequel la résine thermodurcissable est une résine durcie par réaction de polyaddition.

11. Procédé conforme à l'une quelconque des revendications précédentes, dans lequel on dégase la résine thermodurcissable par un traitement thermique à pression réduite avant d'imprégner avec celle-ci le matériau minéral poreux à cellules ouvertes emballé.

12. Procédé conforme à l'une quelconque des revendications précédentes, dans lequel on imprègne le matériau minéral poreux à cellules ouvertes emballé avec la résine thermodurcissable en faisant arriver la résine thermodurcissable depuis le dessous du matériau minéral poreux à cellules ouvertes, à la vitesse d'imprégnation spontanée et à une température pour laquelle la résine thermodurcissable reste liquide.

13. Procédé conforme à l'une quelconque des revendications précédentes dans lequel le matériau composite est tranché au moyen d'une scie multi-fils ou multi-lames.

14. Procédé conforme à la revendication 13, dans lequel la scie multi-fils ou multi-lames est une scie à arête tranchante diamantée.

15. Procédé conforme à l'une quelconque des revendications précédentes dans lequel le matériau composite durci est tranché avec une scie annulaire diamantée sur son diamètre intérieur.
